# EUROPEAN PATENT SPECIFICATION

(11) **EP 4 403 893 B1**
(45) Date of publication and mention of the grant of the patent: **30.07.2025**
(21) Application number: 23218033.1
(22) Date of filing: 19.12.2023
(51) Int. Cl.: G01K 1/16, H05K 1/02, H05K 7/20, H01L 23/495, H01L 23/373, H01L 23/498, H01L 23/538, H01L 23/473, H01L 23/34

(54) **POWER MODULE, CHARGING PILE, AND POWER SUPPLY**
LEISTUNGSMODUL, LADESÄULE UND STROMVERSORGUNG
MODULE D'ALIMENTATION, PILE DE CHARGE ET ALIMENTATION ÉLECTRIQUE

(30) Priority: 19.01.2023 CN 202320264881 U
(43) Date of publication of application: 24.07.2024
(73) Proprietor: Huawei Digital Power Technologies Co., Ltd., Shenzhen, 518043 (CN)
(72) Inventor: DANG, Xinghua, Shenzhen, 518043 (CN); CHEN, Jiansheng, Shenzhen, 518043 (CN); ZHOU, Renyou, Shenzhen, 518043 (CN)
(74) Representative: Epping - Hermann - Fischer

(56) References cited:
- DE-A1- 102013 213 448
- DE-A1- 102021 202 197
- GB-A- 2 337 121
- US-A1- 2012 248 094

## Description

### TECHNICAL FIELD

This application relates to the field of electronic device technologies, and in particular, to a power module, a charging pile, and a power supply.

### BACKGROUND

A power module is a module formed by combining electronic power components according to specific functions. In some electronic devices such as a charging pile and a power supply that use liquid cooling for heat dissipation, the electronic device may include a power module and a liquid cooling plate. The power module may include a power semiconductor and a substrate. The power semiconductor is disposed on the substrate. The power semiconductor is electrically connected to the substrate. A heat sink is disposed on a side that is of the power semiconductor and that is away from the substrate. The liquid cooling plate may perform heat exchange with the heat sink, so that the power semiconductor can dissipate heat by using the liquid cooling plate.

To trigger the electronic device to perform over-temperature protection when the liquid cooling plate is abnormal, in a conventional technology, the power module further includes a plug-in temperature-sensitive resistor. The plug-in temperature-sensitive resistor is fastened onto the heat sink by using a locking structure, the plug-in temperature-sensitive resistor is provided with a pin, the plug-in temperature-sensitive resistor is plugged into the substrate by using the pin to electrically connect to the substrate, and the plug-in temperature-sensitive resistor is configured to collect a temperature of the heat sink. The electronic device determines, based on the temperature of the heat sink, whether over-temperature protection needs to be performed. German patent DE 10 2013 213448 A1 discloses a power module with a temperature sensor on a side of a substrate opposite the heat-emitting component, while further patents US 2012/248094 A1, DE 10 2021 202197 A1 and GB 2 337 121 A provide the temperature sensor on the same side.

However, in the conventional technology, the electronic device has low accuracy in determining whether over-temperature protection needs to be performed, and a case of missing protection may easily occur.

### SUMMARY

Embodiments of this application provide a power module, a charging pile, and a power supply. A projection of a temperature sensor, which is disposed on a surface of a substrate, in a thickness dimension of the substrate overlaps at least partially with a projection of a conductive structure, which is electrically connected to and performs heat exchange with a heat-emitting component, in the thickness dimension of the substrate, so that whether an electronic device needs over-temperature protection can be determined based on a temperature of the conductive structure that is collected by the temperature sensor, thereby improving determining accuracy.

According to a first aspect of embodiments of this application, a power module is provided, including a substrate, a heat-emitting component, and a temperature sensor. The heat-emitting component and the temperature sensor are both disposed on a surface of the substrate, and the heat-emitting component and the temperature sensor are insulated from each other. The substrate includes a conductive structure, the heat-emitting component is electrically connected to the conductive structure, and the conductive structure is configured to perform heat exchange with the heat-emitting component electrically connected to the conductive structure. A projection of the temperature sensor in a thickness dimension of the substrate overlaps at least partially with a projection of the conductive structure in the thickness dimension of the substrate, and the temperature sensor is configured to collect a temperature of the conductive structure.

According to the power module provided in this embodiment of this application, the temperature sensor collects the temperature of the conductive structure electrically connected to the heat-emitting component. The temperature of the conductive structure is less affected by a temperature of a liquid cooling plate, and temperature changes are relatively consistent between the conductive structure and the heat-emitting component electrically connected to the conductive structure. An electronic device may determine, based on the temperature of the conductive structure electrically connected to the heat-emitting component, whether over-temperature protection needs to be performed, and has relatively high accuracy in determining whether over-temperature protection needs to be performed. In addition, because the temperature sensor is disposed on the surface of the substrate, no special design is required for a component such as a heat sink so as to install the temperature sensor, and it is also relatively easy to assemble the temperature sensor. In addition, the temperature sensor is disposed on the surface of the substrate, and is unlikely to connect to a protection earthing. Therefore, safety isolation difficulty of the temperature sensor is relatively low. In addition, the temperature sensor determines, by collecting the temperature of the conductive structure connected to the heat-emitting component, whether over-temperature protection needs to be performed. The heat-emitting component may be various heat-emitting components, such as a power semiconductor, a capacitor, or a magnetic component. A location of the temperature sensor is arranged more flexibly, and it is more flexible to determine whether over-temperature protection needs to be performed.

In a possible implementation, the projection of the temperature sensor in the thickness dimension of the substrate falls within the projection of the conductive structure in the thickness dimension of the substrate.

The substrate is a printed circuit board.

The substrate includes at least two conductive layers and an insulation layer that is located between two adjacent conductive layers. The at least two conductive layers include a first conductive layer and a second conductive layer that are respectively located on surfaces that are of the substrate and that are on two sides of the substrate in the thickness dimension of the substrate. The temperature sensor is disposed on a surface of the first conductive layer, and the heat-emitting component is disposed on the surface of the first conductive layer or a surface of the second conductive layer. At least one conductive layer other than the first conductive layer includes the conductive structure, and there is the insulation layer between the conductive layer in which the conductive structure is located and the first conductive layer.

In a possible implementation, the second conductive layer includes the conductive structure.

In a possible implementation, the substrate includes at least three conductive layers, and the at least three conductive layers further include a third conductive layer that is located between the first conductive layer and the second conductive layer. The third conductive layer includes the conductive structure.

In a possible implementation, the temperature sensor is mounted on the surface of the substrate.

The heat-emitting component is provided with a pin, the pin passes through the substrate so as to dispose the heat-emitting component on the surface of the substrate, the heat-emitting component is electrically connected to the conductive structure by using the pin, the conductive structure is configured to perform heat exchange with the heat-emitting component by using the pin, and the temperature sensor and the pin are adjacently disposed.

In a possible implementation, the power module further includes a heat sink. The heat sink is disposed on a side that is of the heat-emitting component and that is away from the substrate, the heat sink is configured to perform heat exchange with the heat-emitting component, and the temperature sensor and the heat sink are disposed at an interval. In a possible implementation, the heat-emitting component is disposed on a surface that is of the substrate and that is on one side of the substrate in the thickness dimension of the substrate, and the temperature sensor is disposed on a surface that is of the substrate and that is on the other side of the substrate in the thickness dimension of the substrate. According to a second aspect of embodiments of this application, a charging pile is provided, including a pile body, a liquid cooling plate, and the power module in any one of the foregoing implementations. The liquid cooling plate, a substrate, a heat-emitting component, and a temperature sensor are all disposed in the pile body. The heat-emitting component and the temperature sensor are both disposed on a surface of the substrate. The substrate includes a conductive structure, the heat-emitting component is electrically connected to the conductive structure, and the conductive structure is configured to perform heat exchange with the heat-emitting component electrically connected to the conductive structure. A projection of the temperature sensor in a thickness dimension of the substrate overlaps at least partially with a projection of the conductive structure in the thickness dimension of the substrate, and the temperature sensor is configured to collect a temperature of the conductive structure. The heat-emitting component is located between the substrate and the liquid cooling plate, and the liquid cooling plate is configured to perform heat exchange with the heat-emitting component.

According to a thirdaspect of embodiments of this application, a power supply is provided, including a housing, a liquid cooling plate, and the power module in any one of the foregoing implementations. The liquid cooling plate, a substrate, a heat-emitting component, and a temperature sensor are all disposed in the housing. The heat-emitting component and the temperature sensor are both disposed on a surface of the substrate. The substrate includes a conductive structure, the heat-emitting component is electrically connected to the conductive structure, and the conductive structure is configured to perform heat exchange with the heat-emitting component electrically connected to the conductive structure. A projection of the temperature sensor in a thickness dimension of the substrate overlaps at least partially with a projection of the conductive structure in the thickness dimension of the substrate, and the temperature sensor is configured to collect a temperature of the conductive structure. The heat-emitting component is located between the substrate and the liquid cooling plate, and the liquid cooling plate is configured to perform heat exchange with the heat-emitting component.

### BRIEF DESCRIPTION OF DRAWINGS

FIG. 1 is a schematic diagram of an electronic device according to an embodiment of this application;
FIG. 2 is a schematic diagram of a power module according to an embodiment of this application;
FIG. 3 is a schematic diagram of another power module according to an embodiment of this application;
FIG. 4 is a flowchart of a method for determining, by an electronic device, whether to perform over-temperature protection according to an embodiment of this application;
FIG. 5 is a temperature rise curve diagram of a conductive structure of an electronic device in a scenario according to an embodiment of this application;
FIG. 6 is a temperature rise curve diagram of a conductive structure of an electronic device in another scenario according to an embodiment of this application;
FIG. 7 is a temperature rise curve diagram of a conductive structure of an electronic device in still another scenario according to an embodiment of this application;
FIG. 8 is a temperature rise curve diagram of a conductive structure of an electronic device in yet another scenario according to an embodiment of this application; and
FIG. 9 is a schematic diagram of another electronic device according to an embodiment of this application.

### Reference numerals:

100: power module;
110: substrate; 111: first conductive layer; 112: second conductive layer; 113: third conductive layer; 114: conductive structure; 115: insulation layer;
120: heat-emitting component; 121: first pin;
130: temperature sensor;
140: heat sink;
200: liquid cooling plate;
300: housing;
400: memory;
500: processor.

### DESCRIPTION OF EMBODIMENTS

Terms used in implementations of this application are merely used to explain specific embodiments of this application, but are not intended to limit this application. The following describes implementations of embodiments of this application in detail with reference to the accompanying drawings.

An electronic device provided in embodiments of this application may include but is not limited to a charging pile, a power supply, an inverter, a frequency converter, a server, a power distribution box, and the like.

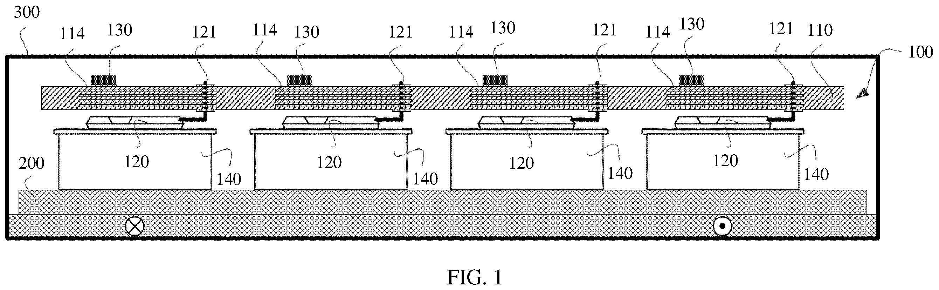

FIG. 1 is a schematic diagram of an electronic device according to an embodiment of this application.

As shown in FIG. 1, in this embodiment of this application, the electronic device includes a housing 300, a power module 100, and a liquid cooling plate 200. The liquid cooling plate 200 and the power module 100 may be both disposed in the housing 300. The liquid cooling plate 200 is configured to perform heat exchange with the power module 100, so that the power module 100 can dissipate heat by using the liquid cooling plate 200.

It can be understood that, the liquid cooling plate 200 has a refrigerant inlet and a refrigerant outlet; and the refrigerant inlet and the refrigerant outlet are respectively connected to two ends of a refrigerant circulation pipe, to form a refrigerant circulation loop. A heat dissipation apparatus, a refrigerant drive apparatus, and the like may be disposed on the refrigerant circulation pipe.

It can be understood that the housing 300 may be designed based on an appearance of the electronic device. When the electronic device is a charging pile, the housing 300 may be a pile body.

In this embodiment of this application, the power module 100 includes a substrate 110 and a heat-emitting component 120. The heat-emitting component 120 is disposed on a surface of the substrate 110, the heat-emitting component 120 is electrically connected to the substrate 110, and the heat-emitting component 120 may be powered by using the substrate 110.

It can be understood that the heat-emitting component 120 may be located between the substrate 110 and the liquid cooling plate 200, and the heat-emitting component 120 is configured to perform heat exchange with the liquid cooling plate 200, so that the heat-emitting component 120 dissipates heat by using the liquid cooling plate 200.

Because the refrigerant circulation pipe connected to the liquid cooling plate 200 may be easily blocked, the electronic device is prone to an abnormal heat dissipation state, such as a blocked-liquid state of the liquid cooling plate, a short-of-liquid state of the liquid cooling plate, a liquid-free state of the liquid cooling plate, or a dead-liquid state of the liquid cooling plate. The power module 100 may further include a temperature sensor 130, to collect a temperature of the power module 100. The electronic device may determine, based on the temperature collected by the temperature sensor 130, whether over-temperature protection needs to be performed.

In a conventional technology, a heat-emitting component of a power module includes a power semiconductor, a heat sink is disposed on a side that is of the power semiconductor and that is away from a substrate, and a liquid cooling plate may contact the heat sink, so that the power semiconductor may perform heat exchange with the liquid cooling plate by using the heat sink disposed on the side of the power semiconductor. A temperature sensor of the power module is a plug-in temperature-sensitive resistor. The plug-in temperature-sensitive resistor is fastened onto the heat sink by using a locking structure. The plug-in temperature-sensitive resistor is provided with a pin, the plug-in temperature-sensitive resistor is plugged into the substrate by using the pin to electrically connect to the substrate, the plug-in temperature-sensitive resistor is powered by using the substrate, and the plug-in temperature-sensitive resistor is configured to collect a temperature of the heat sink. The electronic device determines, based on the temperature of the heat sink, whether over-temperature protection needs to be performed.

However, in the conventional technology, when the electronic device is in a state such as a power-on state, a temperature of the liquid cooling plate is relatively low. Because the temperature of the heat sink is greatly affected by the temperature of the liquid cooling plate, a relatively large temperature difference may exist between the power semiconductor and the heat sink disposed on the power semiconductor. To be specific, when the power semiconductor is already in an over-temperature state, the temperature of the heat sink on the power semiconductor may be relatively low. In this case, there is low accuracy in determining whether over-temperature protection needs to be performed based on the temperature of the heat sink, and a case of missing protection may easily occur. In addition, to enable the heat sink to fasten the plug-in temperature sensitive resistor and enable the plug-in temperature sensitive resistor to collect the temperature of the heat sink, the corresponding locking structure needs to be disposed on the heat sink and a heat-conducting material needs to be coated. A structure of the heat sink is relatively complex, the heat sink needs to be specially designed, and assembly of the plug-in temperature sensitive resistor is also relatively complex. In addition, the heat sink is usually connected to a protective earthing (Protective Earthing, PE), and the plug-in temperature-sensitive resistor fastened onto the heat sink is likely to connect to the protection ground by using the heat sink. After the plug-in temperature-sensitive resistor is connected to the protective earthing, a potential of the plug-in temperature-sensitive resistor is low, and it is relatively difficult to perform safety isolation for the plug-in temperature-sensitive resistor on the substrate. In addition, the plug-in temperature-sensitive resistor can collect only a temperature at the power semiconductor on which the heat sink is disposed but cannot collect a temperature at a heat-emitting component such as a magnetic component or a capacitor on which no heat sink is disposed; and cannot determine, based on the temperature at the heat-emitting component such as the magnetic component or the capacitor on which no heat sink is disposed, whether the electronic device needs to perform over-temperature protection. Therefore, a relatively large limitation exists in determining whether the electronic device needs to perform over-temperature protection.

Therefore, in this embodiment of this application, the temperature sensor 130 of the power module 100 is disposed on the surface of the substrate 110, and the heat-emitting component 120 and the temperature sensor 130 are insulated from each other. The substrate 110 includes a conductive structure 114, the heat-emitting component 120 is electrically connected to the conductive structure 114, and the conductive structure 114 is configured to perform heat exchange with the heat-emitting component 120 electrically connected to the conductive structure 114. A projection of the temperature sensor 130 in a thickness dimension of the substrate 110 overlaps at least partially with a projection of the conductive structure 114 in the thickness dimension of the substrate 110. The temperature sensor 130 is configured to collect a temperature of the conductive structure 114.

It can be understood that the heat-emitting component 120 may include but is not limited to a power semiconductor, a capacitor, a magnetic component, or the like. For example, the heat-emitting component 120 may be a power diode, a power MOSFET, a power IGBT, a power inductor, a power transformer, or the like.

In this way, the temperature sensor 130 collects the temperature of the conductive structure 114 electrically connected to the heat-emitting component 120. The temperature of the conductive structure 114 is less affected by a temperature of the liquid cooling plate 200, and temperature changes are relatively consistent between the conductive structure 114 and the heat-emitting component 120 electrically connected to the conductive structure 114. The electronic device may determine, based on the temperature of the conductive structure 114 electrically connected to the heat-emitting component 120, whether over-temperature protection needs to be performed, and has relatively high accuracy in determining whether over-temperature protection needs to be performed. In addition, the temperature sensor 130 is disposed on the surface of the substrate 110, and no special design is required for a component such as a heat sink 140 so as to install the temperature sensor 130, and it is also relatively easy to assemble the temperature sensor 130. In addition, the temperature sensor 130 is disposed on the surface of the substrate 110, and is unlikely to connect to the protective earthing. Therefore, safety isolation difficulty of the temperature sensor 130 is relatively low. In addition, the temperature sensor 130 determines, by collecting the temperature of the conductive structure 114 connected to the heat-emitting component 120, whether over-temperature protection needs to be performed. The heat-emitting component 120 may be various heat-emitting components 120, such as a power semiconductor, a capacitor, or a magnetic component. A location of the temperature sensor 130 is arranged more flexibly, and it is more flexible to determine whether over-temperature protection needs to be performed.

It can be understood that the conductive structure 114 is made of a thermally-conductive and electrically-conductive material. For example, the conductive structure 114 may be made of a metal material such as copper or aluminum.

It can be understood that the temperature sensor 130 may be disposed in a correspondence with the heat-emitting component 120. The power module 100 may include a plurality of heat-emitting components 120 of a same type and the temperature sensors 130 that are in a one-to-one correspondence with the plurality of heat-emitting components 120 of the same type. It needs to be noted that, the heat-emitting components 120 of the same type refer to heat-emitting components 120 that are of a same component type and have a same function in the power module 100. For example, a plurality of output power-diodes at an output end of the power module 100 may be the plurality of heat-emitting components 120 of the same type. For another example, a plurality of input capacitors at an input end of the power module 100 may be the plurality of heat-emitting components 120 of the same type. After the electronic device is powered on, temperature changes of the heat-emitting components 120 of the same type are relatively consistent. When the power module 100 includes the plurality of heat-emitting components 120 of the same type and the temperature sensors 130 that are in a one-to-one correspondence with the plurality of heat-emitting components 120 of the same type, a projection of each temperature sensor 130 in the thickness dimension of the substrate 110 overlaps at least partially with a projection of the conductive structure 114 electrically connected to the corresponding heat-emitting component 120 in the thickness dimension of the substrate 110, and each temperature sensor 130 is configured to collect a temperature of the conductive structure 114 electrically connected to the corresponding heat-emitting component 120.

It can be understood that, when the power module 100 includes the plurality of heat-emitting components 120 of the same type and the temperature sensors 130 that are in a one-to-one correspondence with the plurality of heat-emitting components 120 of the same type, relative positions of the plurality of heat-emitting components 120 of the same type and the corresponding temperature sensors 130 are as consistentas possible, and types of components disposed between the plurality of heat-emitting components 120 of the same type and the corresponding temperature sensors 130 are also as same as possible, so that temperatures collected by the plurality of temperature sensors 130 are more consistent.

Certainly, only one temperature sensor 130, which corresponds to one heat-emitting component 120 of the power module 100, may be disposed.

In this embodiment of this application, the projection of the temperature sensor 130 in the thickness dimension of the substrate 110 falls within the projection of the conductive structure 114 electrically connected to the corresponding heat-emitting component 120 in the thickness dimension of the substrate 110.

In this way, the temperature collected by the temperature sensor 130 is less affected by another component, and there is relatively high accuracy in determining, based on the temperature of the conductive structure 114 collected by the temperature sensor 130, whether over-temperature protection needs to be performed.

The substrate 110 is a printed circuit board.

In this way, it is convenient to install the heat-emitting component 120 and the temperature sensor 130 on the substrate 110. In addition, the substrate 110 is relatively thin, and it is relatively easy and accurate for the temperature sensor 130 on the surface of the substrate 110 to collect the temperature of the conductive structure electrically connected to the corresponding heat-emitting component 120.

It can be understood that the conductive structure 114 electrically connected to the heat-emitting component 120 is part of the circuit printed in a conductive layer of the printed circuit board, and the circuit in the conductive layer of the printed circuit board may be printed by etching copper foil.

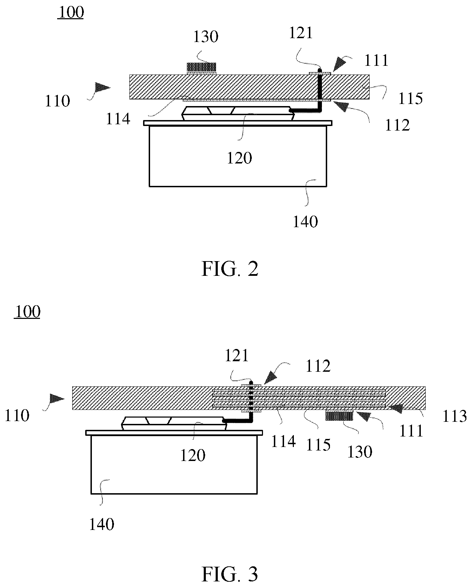

FIG. 2 is a schematic diagram of a power module according to an embodiment of this application.

As shown in FIG. 2, in this embodiment of this application, the substrate 110 includes at least two conductive layers and an insulation layer 115 that is located between two adjacent conductive layers. The at least two conductive layers include a first conductive layer 111 and a second conductive layer 112 that are respectively located on surfaces that are of the substrate 110 and that are on two sides of the substrate 110 in the thickness dimension of the substrate 110. The temperature sensor 130 is disposed on a surface of the first conductive layer 111, and the corresponding heat-emitting component 120 is disposed on the surface of the first conductive layer 111 or a surface of the second conductive layer 112. At least one conductive layer includes the conductive structure 114, and there is the insulation layer 115 between the conductive layer in which the conductive structure 114 is located and the first conductive layer 111. In other words, at least one of the other conductive layers than the first conductive layer 111 includes the conductive structure 114 configured for the temperature sensor 130 to collect a temperature.

In this way, it is convenient to install the heat-emitting component 120 and the temperature sensor 130, and a distance between the temperature sensor 130 and the conductive structure 114 electrically connected to the corresponding heat-emitting component 120 is relatively short, to help the temperature sensor 130 collect the temperature of the conductive structure 114 electrically connected to the corresponding heat-emitting component 120.

It can be understood that, the first conductive layer 111 may include a connection structure, such as a pad, for connecting the temperature sensor 130, so as to dispose the temperature sensor 130 on the surface of the first conductive layer 111; and at least one of the first conductive layer 111 and the second conductive layer 112 includes a connection structure, such as a pad, for connecting the heat-emitting component 120, so as to dispose the heat-emitting component 120 on the surface of the first conductive layer 111 or the surface of the second conductive layer 112.

It can be understood that, the temperature sensor 130 and the corresponding heat-emitting component 120 may be disposed on a surface that is of the substrate 110 and that is on a same side, that is, the temperature sensor 130 and the corresponding heat-emitting component 120 may be both disposed on the surface of the first conductive layer 111. Alternatively, the temperature sensor 130 may be disposed on a surface that is of the substrate 110 and that is on one side of the substrate 110 in the thickness dimension of the substrate 110, and the corresponding heat-emitting component 120 is disposed on a surface that is of the substrate 110 and that is on the other side of the substrate 110 in the thickness dimension of the substrate 110. In other words, the temperature sensor 130 may be disposed on the surface of the first conductive layer 111, and the corresponding heat-emitting component 120 may be disposed on the surface of the second conductive layer 112.

In this embodiment of this application, the second conductive layer 112 includes the conductive structure 114.

In this way, when the substrate 110 is a double-layer circuit board, it is convenient to monitor whether the heat-emitting component 120 disposed on the substrate 110 is overheated.

For example, the substrate 110 includes the first conductive layer 111, the second conductive layer 112, and the insulation layer 115 sandwiched between the first conductive layer 111 and the second conductive layer 112; the temperature sensor 130 is disposed on the surface of the first conductive layer 111; the heat-emitting component 120 is disposed on the surface of the second conductive layer 112; the second conductive layer 112 includes the conductive structure 114; the heat-emitting component 120 is electrically connected to and performs heat exchange with the conductive structure 114 of the second conductive layer 112; and the projection of the temperature sensor 130 in the thickness dimension of the substrate 110 falls within the projection of the conductive structure 114 of the second conductive layer 112 in the thickness dimension of the substrate 110.

For example, the substrate 110 includes the first conductive layer 111, the second conductive layer 112, and the insulation layer 115 sandwiched between the first conductive layer 111 and the second conductive layer 112; the temperature sensor 130 and the heat-emitting component 120 are disposed on the surface of the first conductive layer 111; the second conductive layer 112 includes the conductive structure 114; the heat-emitting component 120 is electrically connected to and performs heat exchange with the conductive structure 114 of the second conductive layer 112; and the projection of the temperature sensor 130 in the thickness dimension of the substrate 110 falls within the projection of the conductive structure 114 of the second conductive layer 112 in the thickness dimension of the substrate 110.

FIG. 3 is a schematic diagram of another power module according to an embodiment of this application.

As shown in FIG. 3, in this embodiment of this application, the substrate 110 includes at least three conductive layers, and the at least three conductive layers further include a third conductive layer 113 that is located between the first conductive layer 111 and the second conductive layer 112. The third conductive layer 113 includes the conductive structure 114.

In this way, when the substrate 110 is a multi-layer circuit board, it is convenient to monitor whether the heat-emitting component 120 disposed on the substrate 110 is overheated.

It can be understood that, when the third conductive layer 113 includes the conductive structure 114 electrically connected to the heat-emitting component 120, the second conductive layer 112 may include the conductive structure 114, or the second conductive layer 112 may exclude the conductive structure 114.

It can be understood that, a plurality of third conductive layers 113 may be disposed between the first conductive layer 111 and the second conductive layer 112, and each third conductive layer 113 may include the conductive structure 114.

For example, the substrate 110 includes four conductive layers and the insulation layer 115 sandwiched between two adjacent conductive layers; the four conductive layers include the first conductive layer 111 and the second conductive layer 112 that are respectively located on surfaces that are of the substrate 110 and that are on two sides of the substrate 110 in the thickness dimension of the substrate 110, and two third conductive layers 113 that are located between the first conductive layer 111 and the second conductive layer 112; the temperature sensor 130 and the heat-emitting component 120 are disposed on the surface of the first conductive layer 111; the two third conductive layers 113 each include the conductive structure 114; the conductive structures 114 of the two third conductive layers 113 are disposed in an overlapping manner; the heat-emitting component 120 is electrically connected to and performs heat exchange with the conductive structures 114 of the two third conductive layers 113; and the projection of the temperature sensor 130 in the thickness dimension of the substrate 110 falls within the projection of the conductive structure 114 in the thickness dimension of the substrate 110.

For example, the substrate 110 includes six conductive layers and the insulation layer 115 sandwiched between two adjacent conductive layers; the six conductive layers include the first conductive layer 111 and the second conductive layer 112 that are respectively located on surfaces that are of the substrate 110 and that are on two sides of the substrate 110 in the thickness dimension of the substrate 110, and four third conductive layers 113 that are located between the first conductive layer 111 and the second conductive layer 112; the temperature sensor 130 is disposed on the surface of the first conductive layer 111; the heat-emitting component 120 is disposed on the surface of the second conductive layer 112; the four third conductive layers 113 each include the conductive structure 114; the conductive structures 114 of the four third conductive layers 113 are disposed in an overlapping manner; the heat-emitting component 120 is electrically connected to and performs heat exchange with the conductive structures 114 of the third conductive layers 113; and the projection of the temperature sensor 130 in the thickness dimension of the substrate 110 falls within the projection of the conductive structure 114 in the thickness dimension of the substrate 110.

In some embodiments of this application, the substrate 110 may alternatively include a copper bar and an insulation structure that is disposed on the copper bar; the heat-emitting component 120 may be disposed on the insulation structure; the heat-emitting component 120 is electrically connected to the copper bar; the copper bar is the conductive structure 114 electrically connected to the heat-emitting component 120; the temperature sensor 130 may be disposed on the insulation structure; and the temperature sensor 130 may be configured to collect a temperature of the copper bar.

In this way, over-temperature monitoring of the heat-emitting component 120 electrically connected to the copper bar can be implemented.

In this embodiment of this application, the heat-emitting component 120 is provided with a first pin 121, the first pin 121 passes through the substrate 110 so as to dispose the heat-emitting component 120 on the surface of the substrate 110, the heat-emitting component 120 is electrically connected to the conductive structure 114 by using the first pin 121, and the conductive structure 114 is configured to perform heat exchange with the heat-emitting component 120 by using the first pin 121.

In this way, the heat-emitting component 120 is electrically connected to and performs heat exchange with the conductive structure 114 in the substrate 110 or on the other side of the substrate 110.

It can be understood that, when the heat-emitting component 120 is disposed on the surface of the substrate 110 by using the first pin 121 that passes through the substrate 110, the heat-emitting component 120 is a plug-in component; and a connection structure, such as a pad, for connecting to the first pin 121 is disposed on both sides of the substrate 110 in the thickness dimension of the substrate 110.

It can be understood that the heat-emitting component 120 may be provided with a plurality of pins, and one of the pins may be the first pin 121.

In this embodiment of this application, the temperature sensor 130 and the first pin 121 are adjacently disposed.

In this way, an error between the temperature collected by the temperature sensor 130 and a temperature of the first pin 121 or a temperature of the heat-emitting component 120 is relatively small.

It can be understood that the temperature sensor 130 and the first pin 121 are adjacently disposed means that a spacing between the temperature sensor 130 and the first pin 121 may be as small as possible on a basis of satisfying safety isolation.

In some embodiments of this application, the temperature sensor 130 is mounted on the surface of the substrate 110. In this way, a spacing between the temperature sensor 130 and the conductive structure 114 may be relatively small, to help the temperature sensor 130 collect the temperature of the conductive structure 114; and a connection between the temperature sensor 130 and the substrate 110 is also relatively stable. In addition, compared with a plug-in temperature sensor, the temperature sensor 130 has less impact on the arrangement of the conductive structure 114.

It can be understood that the temperature sensor 130 may be a surface-mount temperature-sensitive resistor, and the surface-mount temperature-sensitive resistor may be mounted on the surface of the substrate 110 by using a connection structure such as a pad on the surface of the substrate 110.

In some embodiments of this application, the temperature sensor 130 may be provided with a second pin, and the second pin passes through the substrate 110, so that the temperature sensor 130 is disposed on the surface of the substrate 110; the second pin and the conductive structure 114 are disposed at an interval, so that the second pin and the conductive structure 114 are insulated from each other; and the second pin may be in a bent state, so that the projection of the temperature sensor 130 in the thickness dimension of the substrate 110 overlaps at least partially with the projection of the conductive structure 114 in the thickness dimension of the substrate 110.

It can be understood that, when the temperature sensor 130 is disposed on the surface of the substrate 110 by using the second pin that passes through the substrate 110, the temperature sensor 130 is a plug-in temperature sensor; and a connection structure, such as a pad, for connecting to the second pin is disposed on both sides of the substrate 110 in the thickness dimension of the substrate 110.

In this embodiment of this application, the heat-emitting component 120 is disposed on a surface that is of the substrate 110 and that is on one side of the substrate 110 in the thickness dimension of the substrate 110, and the temperature sensor 130 is disposed on a surface that is of the substrate 110 and that is on the other side of the substrate 110 in the thickness dimension of the substrate 110.

In this way, the temperature sensor 130 is relatively far away from the liquid cooling plate 200, to reduce impact of the liquid cooling plate 200 configured to perform heat exchange with the heat-emitting component 120 on temperature collection by the temperature sensor 130, so that accuracy of the temperature of the conductive structure 114 collected by the temperature sensor 130 is higher.

In this embodiment of this application, the power module 100 further includes the heat sink 140. The heat sink 140 is disposed on a side that is of the heat-emitting component 120 and that is away from the substrate 110. The heat sink 140 is configured to perform heat exchange with the heat-emitting component 120. The temperature sensor 130 and the heat sink 140 are disposed at an interval.

In this way, heat dissipation efficiency of the heat-emitting component 120 provided with the heat sink 140 is improved. The temperature sensor 130 and the heat sink 140 are disposed at the interval, and the temperature sensor 130 is unlikely to connect to the protective earthing by using the heat sink 140.

It can be understood that the heat sink 140 may be bonded, by using a thermal interface material (Thermal Interface Material, TIM), to the side that is of the heat-emitting component 120 and that is away from the substrate 110.

It can be understood that, the heat sink 140 disposed on one side of the heat-emitting component 120 may be in contact with the liquid cooling plate 200, or may be bonded to the liquid cooling plate 200 by using the thermal interface material, so that the heat-emitting component 120 can perform heat exchange with the liquid cooling plate 200 by using the heat sink 140.

When the heat sink 140 is not disposed on the heat-emitting component 120, the heat-emitting component 120 may be in contact with the liquid cooling plate 200, or may be bonded to the liquid cooling plate 200 by using the thermal interface material, so that the heat-emitting component 120 can perform heat exchange with the liquid cooling plate 200.

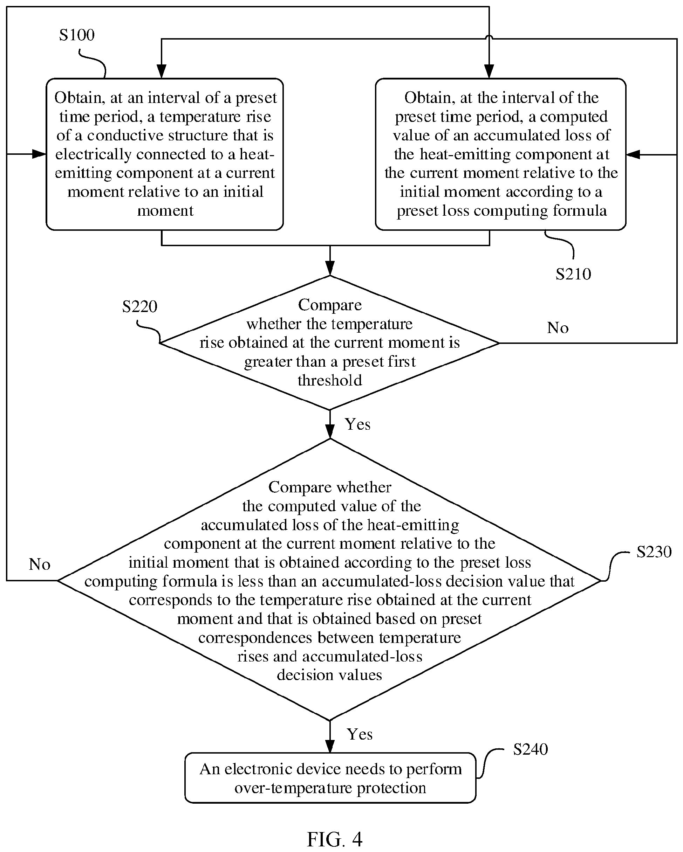

FIG. 4 is a flowchart of an embodiment of a method for determining, by an electronic device, whether to perform over-temperature protection according to an embodiment of this application.

As shown in FIG. 4, an embodiment of this application further provides a method for determining, by an electronic device, whether to perform over-temperature protection. The determining method includes the following steps.

S100: Obtain, at an interval of a preset time period, a temperature rise of a conductive structure that is electrically connected to a heat-emitting component at a current moment relative to an initial moment, where the heat-emitting component is a component whose temperature rise and accumulated loss are in a positive correlation with each other, for example, may be an output power diode, a power MOSFET, a power IGBT, a capacitor, a power inductor, a power transformer, or the like.

It can be understood that, the initial moment may be a moment at which the electronic device is powered on; and after the electronic device is powered on, the electronic device may be in a standby state or a working state.

It can be understood that, the temperature rise of the conductive structure that is electrically connected to the heat-emitting component at the current moment relative to the initial moment may be obtained based on a difference between a temperature of the conductive structure that is obtained by a temperature sensor on a surface of a substrate at the current moment and a temperature of the conductive structure that is obtained by the temperature sensor at the initial moment.

S200: Determine, based on the temperature rise of the conductive structure that is electrically connected to the heat-emitting component at the current moment relative to the initial moment, whether the electronic device needs to perform over-temperature protection.

In this way, the temperature rise of the conductive structure is less affected by a temperature of a liquid cooling plate, and temperature changes are relatively consistent between the conductive structure and the heat-emitting component electrically connected to the conductive structure. Therefore, it is relatively accurate to determine, based on the temperature rise of the conductive structure, whether the electronic device needs to perform over-temperature protection. In addition, the determining, based on the temperature rise rather than an absolute temperature, whether the electronic device needs to perform over-temperature protection can reduce impact of an ambient temperature on the judgment, so that the judgment is more accurate.

It can be understood that, when a power module of the electronic device includes a plurality of heat-emitting components of a same type, the temperature rise in the method for determining whether the electronic device needs to perform over-temperature protection may be a maximum value or an average value of temperature rises of conductive structures that are respectively and electrically connected to the plurality of heat-emitting components of the same type. In other words, the temperature rise used to determine whether the electronic device needs to perform over-temperature protection may be the maximum value or the average value of the temperature rises of the conductive structures that are respectively and electrically connected to the plurality of heat-emitting components of the same type.

In this embodiment of this application, the step S200 specifically includes the following steps.

S210: Obtain, at the interval of the preset time period, a computed value of an accumulated loss of the heat-emitting component at the current moment relative to the initial moment according to a preset loss computing formula.

It can be understood that, the preset loss computing formula may include an instantaneous-loss computing formula. A computed value of an instantaneous loss of the heat-emitting component at the current moment may be obtained according to the instantaneous-loss computing formula and information such as a voltage, a current, and a switching frequency of the heat-emitting component at the current moment; and then the computed value of the accumulated loss of the heat-emitting component at the current moment relative to the initial moment is obtained by accumulating computed values of instantaneous losses of the heat-emitting component that are obtained between the current moment and the initial moment. When a working condition of the electronic device is fixed, computed values of instantaneous losses at all moments between the current moment and the initial moment are the same, and the computed value of the accumulated loss of the heat-emitting component at the current moment relative to the initial moment may be obtained by multiplying the computed value of the instantaneous loss by a time difference between the current moment and the initial moment.

S220: Compare the temperature rise obtained at the current moment with a preset first threshold.

S230: If the temperature rise obtained at the current moment is greater than the preset first threshold, obtain, based on preset correspondences between temperature rises and accumulated-loss decision values, an accumulated-loss decision value that corresponds to the temperature rise obtained at the current moment; and compare the obtained accumulated-loss decision value that corresponds to the temperature rise obtained at the current moment with the computed value of the accumulated loss of the heat-emitting component at the current moment relative to the initial moment that is obtained according to the preset loss computing formula. In a range in which the temperature rise is greater than a third threshold but less than a second threshold, an accumulated-loss decision value that corresponds to any temperature rise and that is obtained based on the preset correspondences between temperature rises and accumulated-loss decision values is less than a computed value of an accumulated loss of the heat-emitting component that is obtained, according to the preset loss computing formula, when the electronic device in a normal state reaches the same temperature rise; and is greater than a computed value of an accumulated loss of the heat-emitting component that is obtained, according to the preset loss computing formula, when the electronic device in an abnormal heat dissipation state reaches the same temperature rise. The second threshold is equal to a temperature rise of the conductive structure at a moment when the heat-emitting component is damaged due to over-temperature, relative to the initial moment. The second threshold may be obtained based on a difference between a temperature of the conductive structure at the moment when the heat-emitting component is damaged due to over-temperature and a temperature of the conductive structure at the initial moment. The third threshold is less than the second threshold, and the preset first threshold is less than or equal to the third threshold.

It can be understood that, the abnormal heat dissipation state may include a short-of-liquid state of the liquid cooling plate, a blocked-liquid state of the liquid cooling plate, a dead-liquid state of the liquid cooling plate, a liquid-free state of the liquid cooling plate, and the like. In the range in which the temperature rise is greater than the third threshold but less than the second threshold, a computed value of an accumulated loss of the heat-emitting component that is obtained when the electronic device in each heat dissipation abnormal state, such as the short-of-liquid state of the liquid cooling plate, the blocked-liquid state of the liquid cooling plate, the dead-liquid state of the liquid cooling plate, or the liquid-free state of the liquid cooling plate, reaches any temperature rise is less than an accumulated-loss decision value that corresponds to the same temperature rise and that is obtained based on the preset correspondences between temperature rises and accumulated-loss decision values.

It can be understood that, the preset correspondences between temperature rises and accumulated-loss decision values may be a table of the correspondences between temperature rises and accumulated-loss decision values, or may be a curve of the correspondences between temperature rises and accumulated-loss decision values.

In this embodiment of this application, when a temperature rise is equal to the third threshold, an accumulated-loss decision value that corresponds to the third threshold and that is obtained based on the preset correspondences between temperature rises and accumulated-loss decision values may be equal to a computed value of an accumulated loss of the heat-emitting component that is obtained, according to the preset loss computing formula, when the third threshold is reached on the electronic device in the abnormal heat dissipation state.

It can be understood that, in an example, accumulated loss values are horizontal coordinates and temperature rises are vertical coordinates. In a range in which the temperature rise is greater than or equal to the third threshold but less than the second threshold, computed values of accumulated losses that are obtained, according to the preset loss computing formula, when the electronic device is in the normal state may be fitted with corresponding temperature rises of the conductive structure to form a first relationship line. In a rectangular coordinate system in which the first relationship line is located, computed values of accumulated losses that are obtained, according to the preset loss computing formula, when the electronic device is in the abnormal heat dissipation state may be fitted with and corresponding temperature rises of the conductive structure to form a second relationship line. The preset correspondences between temperature rises and accumulated-loss decision values may be fitted to form a third relationship line. The second relationship line is distributed at intervals above the first relationship line. The third relationship line is distributed at intervals above the first relationship line. The third relationship line intersects with the second relationship line at a position whose vertical coordinate is equal to the third threshold. Of the third relationship line, a portion whose vertical coordinates fall within the range greater than the third threshold but less than the second threshold is distributed at intervals below the second relationship line.

In this embodiment of this application, the electronic device may include a plurality of working conditions, such as a full-power output working condition and a half-load power output working condition. For the electronic device in each working condition, in the range in which the temperature rise is greater than the third threshold but less than the second threshold, an accumulated-loss decision value that corresponds to any temperature rise and that is obtained based on the preset correspondences between temperature rises and accumulated-loss decision values is less than a computed value of an accumulated loss of the heat-emitting component that is obtained, according to the preset loss computing formula, when the electronic device in the normal state reaches the same temperature rise; and is greater than a computed value of an accumulated loss of the heat-emitting component that is obtained, according to the preset loss computing formula, when the electronic device in the abnormal heat dissipation state reaches the same temperature rise.

It can be understood that, if the temperature rise obtained at the current moment is less than or equal to the first threshold, the steps S100, S210, and S220 are repeated.

S240: If the temperature rise obtained at the current moment is greater than the preset first threshold, and the computed value of the accumulated loss of the heat-emitting component at the current moment relative to the initial moment that is obtained according to the preset loss computing formula is less than the accumulated-loss decision value that corresponds to the temperature rise obtained at the current moment and that is obtained based on the preset correspondences between temperature rises and accumulated-loss decision values, determine that the electronic device needs to perform over-temperature protection.

It can be understood that, if the computed value of the accumulated loss of the heat-emitting component at the current moment relative to the initial moment that is obtained according to the loss computing formula is not less than the accumulated-loss decision value that corresponds to the temperature rise obtained at the current moment and that is obtained based on the preset correspondences between temperature rises and accumulated-loss decision values, it is determined that the electronic device does not need to perform over-temperature protection; and the steps S100, S210, S220, and S230 are repeated.

In this way, a same judgement standard may be used for judgment in different working conditions and different abnormal heat dissipation states. The judgement logic is relatively simple, and a case of missing protection or mistaken protection is unlikely to occur.

It can be understood that, in the preset correspondences between temperature rises and accumulated-loss decision values, temperature rises in a preset temperature range may correspond to a same accumulated-loss decision value. For example, the preset temperature range may be 1°C, so that temperature rises in a range greater than or equal to ΔT°C but less than ΔT+1°C correspond to a same accumulated-loss decision value.

**Table 1 is a table of preset correspondences between temperature rises and accumulated-loss decision values in an embodiment of a method for determining, by an electronic device, whether to perform over-temperature protection according to an embodiment of this application.**

| x | 1 | 2 | 3 | 4 | 5 | 6 | 7 | 8 | 9 | 10 | 11 | 12 | 13 | 14 | 15 | 16 | 17 | 18 | 19 |
|---|---|---|---|---|---|---|---|---|---|---|---|---|---|---|---|---|---|---|---|
| ΔTₓ | 10 | 11 | 12 | 13 | 14 | 15 | 16 | 17 | 18 | 19 | 20 | 21 | 22 | 23 | 24 | 25 | 26 | 27 | 28 |
| P_{∑x} | 235 | 320 | 405 | 490 | 575 | 660 | 745 | 840 | 945 | 1060 | 1185 | 1305 | 1442 | 1596 | 1767 | 1955 | 2160 | 2382 | 2621 |

As shown in Table 1, ΔTx represents the temperature rise of the conductive structure that is electrically connected to the heat-emitting component at the current moment relative to the initial moment in a unit of °C, and PΣx represents an accumulated-loss decision value in a unit of J. The electronic device may be a charging pile or a power supply. For example, it is assumed that the first threshold is 10°C, when the obtained temperature rise of the conductive structure that is electrically connected to the heat-emitting component at the current moment relative to the initial moment is greater than 10°C but less than 11°C, the computed value of the accumulated loss of the heat-emitting component at the current moment relative to the initial moment that is obtained according to the preset loss computing formula is compared with a value of 235J. If the computed value of the accumulated loss of the heat-emitting component at the current moment relative to the initial moment that is obtained according to the preset loss computing formula is less than 235J, it indicates that the electronic device needs to perform over-temperature protection. If the computed value of the accumulated loss of the heat-emitting component at the current moment relative to the initial moment that is obtained according to the preset loss computing formula is not less than 235J, it indicates that the electronic device does not need to perform over-temperature protection. If it is determined, at the current moment, that over-temperature protection does not need to be performed, the steps S100, S210, S220, and S230 continue and are repeated. For example, at a next moment, an obtained temperature rise of the conductive structure that is electrically connected to the heat-emitting component relative to the initial moment is greater than or equal to 12°C but less than 13°C. In this case, a computed value of an accumulated loss of the heat-emitting component at that current moment relative to the initial moment that is obtained according to the preset loss computing formula is compared with 405J. If the computed value of the accumulated loss of the heat-emitting component at that current moment relative to the initial moment that is obtained according to the preset loss computing formula is less than 405J, it indicates that the electronic device needs to perform over-temperature protection. If the computed value of the accumulated loss of the heat-emitting component at that current moment relative to the initial moment that is obtained according to the preset loss computing formula is not less than 405J, it indicates that the electronic device does not need to perform over-temperature protection.

It can be understood that, after determining that the electronic device needs to perform over-temperature protection, the electronic device may perform a protection action such as power-off or output power reduction.

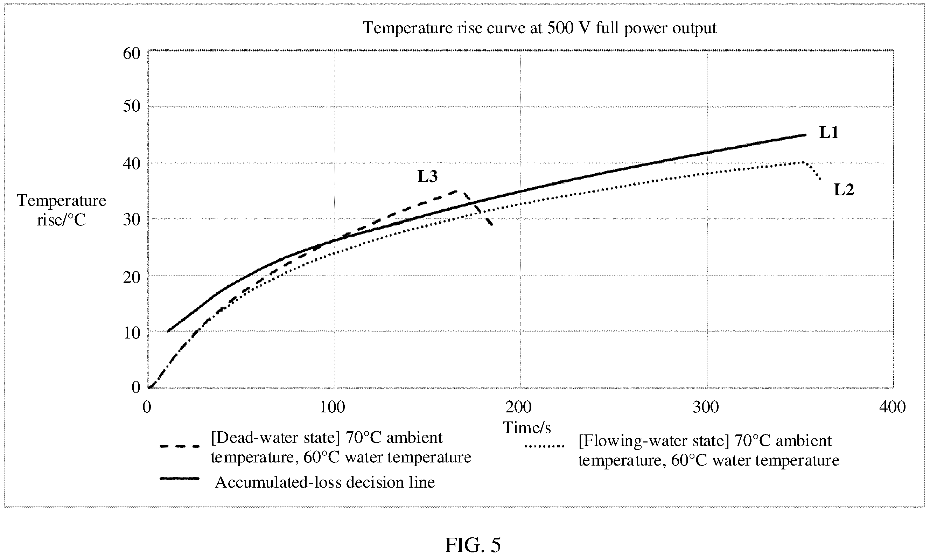

FIG. 5 to FIG. 8 are temperature rise curves of a conductive structure of an electronic device in four different scenarios according to an embodiment of this application. The electronic device may be a charging pile or a power supply. In the figures, horizontal coordinates are time, and vertical coordinates are temperature rises. L1 represents a temperature rise curve of a conductive structure corresponding to an accumulated-loss decision line, that is, L1 is a temperature rise curve of the conductive structure that is obtained based on the preset correspondences between temperature rises and accumulated-loss decision values according to the preset loss computing formula. Specifically, a corresponding time at which an accumulated-loss decision value is reached may be computed according to the preset loss computing formula; and the temperature rise curve of the conductive structure corresponding to the accumulated-loss decision line may be obtained based on the preset correspondences between temperature rises and accumulated-loss decision values and the computed corresponding time at which the accumulated-loss decision value is reached. L2 indicates that the electronic device is in a flowing-water state, that is, a temperature rise curve of the conductive structure when the electronic device is in a normal state, which may be obtained through measurement. L3 indicates that the electronic device is in a dead-water state, that is, a temperature rise curve of the conductive structure when the electronic device is in an abnormal heat dissipation state, which may be obtained through measurement. It can be learned from FIG. 5 to FIG. 8 that, temperature rises of the conductive structure when the electronic device is in the dead-water state are faster than temperature rises of the conductive structure when the electronic device is in the flowing-water state.

As shown in FIG. 5, when an ambient temperature is 70°C, a water temperature in the liquid cooling plate is 60°C, and the electronic device is at 500 V full-power output, L1 is above L2, L1 does not intersect with L2, L1 intersects with L3, a vertical coordinate at a position where L1 intersects with L3 may be the third threshold, and a portion of L1 in a period of time after L1 intersects with L3 is below L3. In other words, in this scenario, it may be determined, based on the preset correspondences between temperature rises and accumulated-loss decision values, that the electronic device is in the dead-water state; and then it is determined that the electronic device needs to perform over-temperature protection, and no false judgment is performed when the electronic device is in the normal state.

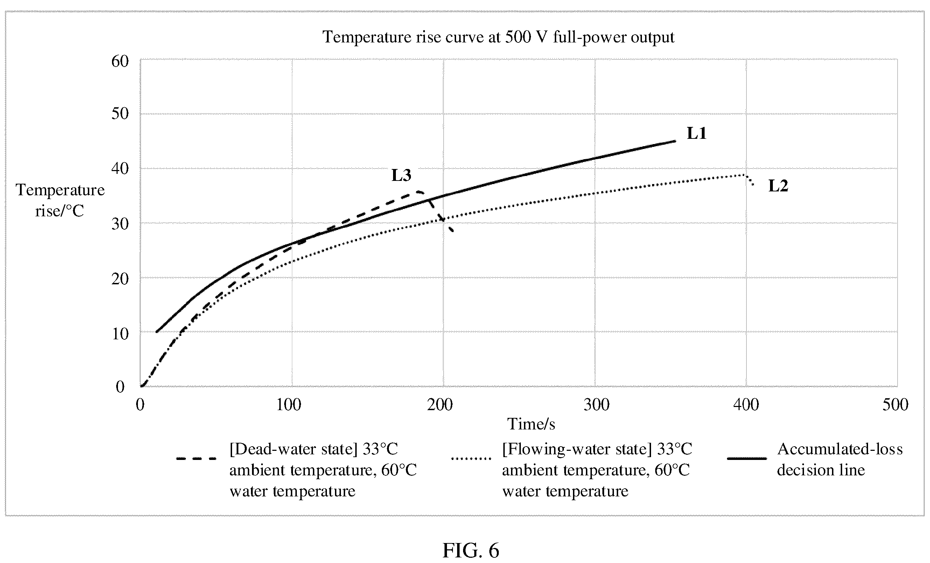

As shown in FIG. 6, when an ambient temperature is 33°C, a water temperature in the liquid cooling plate is 60°C, and the electronic device is at 500 V full-power output, L1 is above L2, L1 does not intersect with L2, L1 intersects with L3, a vertical coordinate at a position where L1 intersects with L3 may be the third threshold, and a portion of L1 in a period of time after L1 intersects with L3 is below L3. In other words, in this scenario, it may be determined, based on the preset correspondences between temperature rises and accumulated-loss decision values, that the electronic device is in the dead-water state; and then it is determined that the electronic device needs to perform over-temperature protection, and no false judgment is performed when the electronic device is in the normal state.

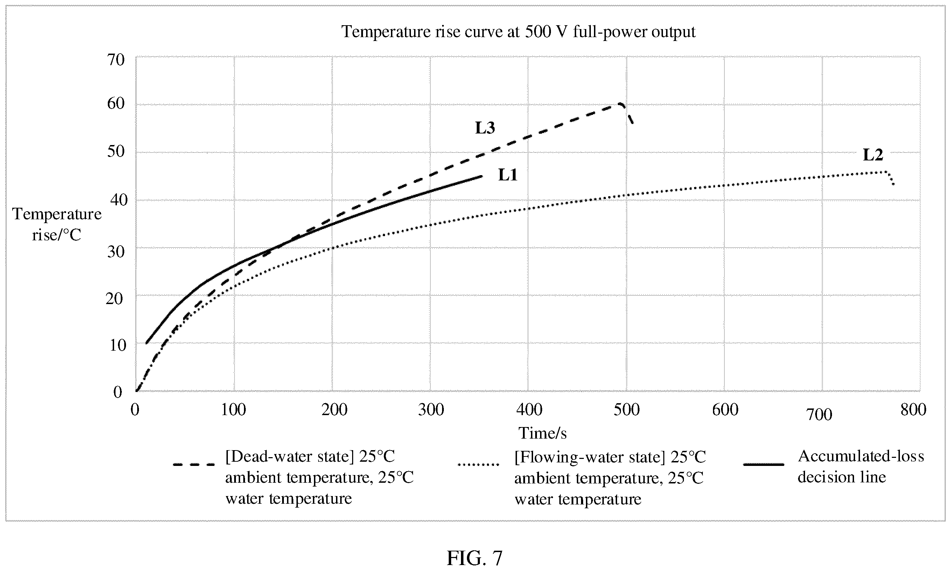

As shown in FIG. 7, when an ambient temperature is 25°C, a water temperature in the liquid cooling plate is 25°C, and the electronic device is at 500 V full-power output, L1 is above L2, L1 does not intersect with L2, L1 intersects with L3, a vertical coordinate at a position where L1 intersects with L3 may be the third threshold, and a portion of L1 in a period of time after L1 intersects with L3 is below L3. In other words, in this scenario, it may be determined, based on the preset correspondences between temperature rises and accumulated-loss decision values, that the electronic device is in the dead-water state; and then it is determined that the electronic device needs to perform over-temperature protection, and no false judgment is performed when the electronic device is in the normal state.

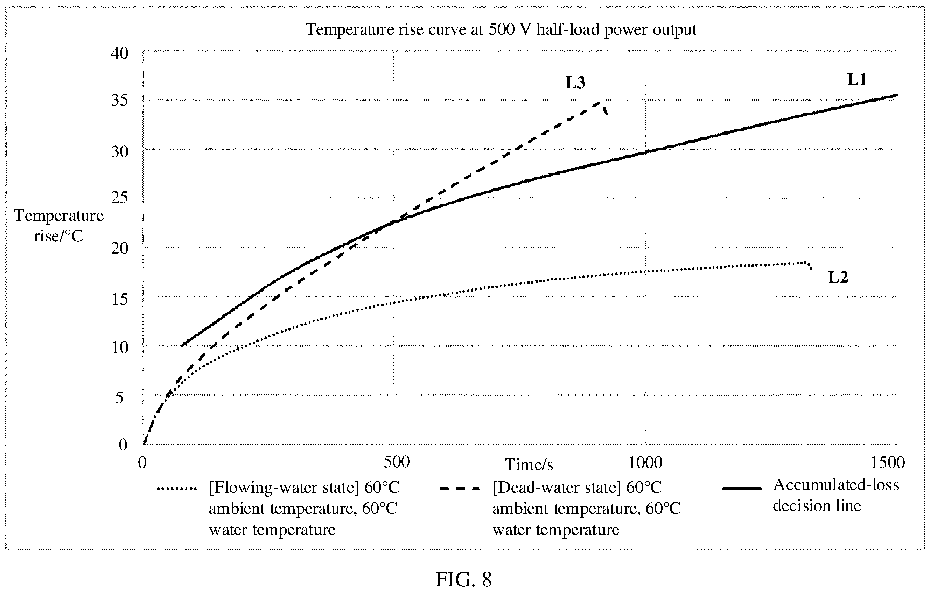

As shown in FIG. 8, when an ambient temperature is 60°C, a water temperature in the liquid cooling plate is 60°C, and the electronic device is at 500 V half-load power output, L1 is above L2, L1 does not intersect with L2, L1 intersects with L3, a vertical coordinate at a position where L1 intersects with L3 may be the third threshold, and a portion of L1 in a period of time after L1 intersects with L3 is below L3. In other words, in this scenario, it may be determined, based on the preset correspondences between temperature rises and accumulated-loss decision values, that the electronic device is in the dead-water state; and then it is determined that the electronic device needs to perform over-temperature protection, and no false judgment is performed when the electronic device is in the normal state.

To obtain the preset loss computing formula and the preset correspondences between temperature rises and accumulated-loss decision values so that, in various working conditions, the electronic device can accurately determine whether to perform over-temperature protection, an embodiment of this application further provides a method for correcting a standard for determining, by the electronic device, whether to perform over-temperature protection. The correction method includes the following steps.

S300: Obtain, in a preset working condition, relationships between temperature rises of a conductive structure that is electrically connected to a heat-emitting component when the electronic device is in a normal state and computed values of accumulated losses that are computed according to a preset loss computing formula; and form a first relationship line in a rectangular coordinate system based on the relationships between the temperature rises of the conductive structure that is electrically connected to the heat-emitting component when the electronic device is in the normal state and the computed values of the accumulated losses that are computed according to the preset loss computing formula.

S400: Obtain, in the preset working condition, relationships between temperature rises of the conductive structure that is electrically connected to the heat-emitting component when the electronic device is in an abnormal heat dissipation state and computed values of accumulated losses that are computed according to the preset loss computing formula; and form, in the rectangular coordinate system in which the first relationship line is located, a second relationship line based on the relationships between the temperature rises of the conductive structure that is electrically connected to the heat-emitting component when the electronic device is in the abnormal heat dissipation state and the computed values of the accumulated losses that are computed according to the preset loss computing formula.

It can be understood that, in the step S400, a temperature of a vulnerable component needs to be obtained, to ensure that the vulnerable component is not damaged in a process of performing the step S400. In other words, the step S400 needs to be performed on a premise that the temperature of the vulnerable component is lower than a temperature causing damage to the vulnerable component . The vulnerable component may be a heat-emitting component electrically connected to the conductive structure, or the vulnerable component may be another component that may be easily damaged due to over-temperature of the electronic device.

S500: Based on the first relationship line and the second relationship line, obtain correspondences between temperature rises and accumulated-loss decision values, so that, in a range in which the temperature rise is greater than a third threshold but less than a second threshold, the correspondences between temperature rises and accumulated-loss decision values satisfy a determining relationship with the first relationship line and the second relationship line. When the correspondences between temperature rises and accumulated-loss decision values satisfy the determining relationship with the first relationship line and the second relationship line, all coordinates, which are formed by accumulated-loss decision values that are obtained according to the correspondences between temperature rises and accumulated-loss decision values and corresponding temperature rises, are located between the first relationship line and the second relationship line in the same rectangular coordinate system; the second threshold is equal to a temperature rise of the conductive structure at a moment when the heat-emitting component is damaged due to over-temperature, relative to an initial moment; the second threshold is greater than the third threshold; and the third threshold is greater than or equal to a first threshold.

It can be understood that, in the rectangular coordinate system in which the first relationship line and the second relationship line are located, a third relationship line may be formed through fitting based on the correspondences between temperature rises and accumulated-loss decision values. In the range in which the temperature rise is greater than the third threshold but less than the second threshold, the third relationship line is located between the first relationship line and the second relationship line in the same rectangular coordinate system.

It can be understood that, when the correspondences between temperature rises and accumulated-loss decision values are obtained based on the first relationship line and the second relationship line, a calibrated temperature rise may be selected between the third threshold and the second threshold. In the preset working condition, when the electronic device is in the normal state, a momentat which a temperature rise of the conductive structure reaches the calibrated temperature rise is t1; and when the electronic device is in the abnormal heat dissipation state, a momentat which the temperature rise of the conductive structure reaches the calibrated temperature rise is t2. A momentt3 between t1 and t2 is selected, where the vulnerable component of the electronic device in the abnormal heat dissipation state is not damaged at t3 starting from the initial moment. A computed value of an accumulated loss at t3 may be obtained according to the preset loss computing formula, so that the computed value of the accumulated loss at t3 and the calibrated temperature rise may be used as a correspondence between a pair of an accumulated-loss decision value and a temperature rise in the correspondences between temperature rises and accumulated-loss decision values. According to this method, by changing the calibrated temperature rise, correspondences between a plurality of pairs of different accumulated-loss decision values and temperature rises may be obtained in the correspondences between temperature rises and accumulated-loss decision values. After the correspondences between temperature rises and accumulated-loss decision values are obtained, the correspondences between temperature rises and accumulated-loss decision values may be fixed, so that the correspondences between temperature rises and accumulated-loss decision values are not affected by a change in the preset loss computing formula.

In this embodiment of this application, when a temperature rise is equal to the third threshold, coordinates, which are formed by an accumulated-loss decision value that is obtained based on the correspondences between temperature rises and accumulated-loss decision values and the corresponding temperature rise, may be located on the second relationship line in the same rectangular coordinate system.

S600: Change the preset working condition, repeat S300 and S400, and verify, in a current working condition, whether the correspondences between temperature rises and accumulated-loss decision values satisfy the determining relationship with the first relationship line and the second relationship line in the range in which the temperature rise is greater than the third threshold but less than the second threshold; and if a verification result is no, correct at least one of the preset loss computing formula and the correspondences between temperature rises and accumulated-loss decision values, so that, in the current working condition and in the working condition before the preset working condition is changed, the correspondences between temperature rises and accumulated-loss decision values satisfy the determining relationship with the first relationship line and the second relationship line in the range in which the temperature rise is greater than the third threshold but less than the second threshold.

It can be understood that, after the preset working condition is changed, if the verification result in the current working condition is yes, the preset loss computing formula and the correspondences between temperature rises and accumulated-loss decision values do not need to be corrected.

It can be understood that, during the correction of the at least one of the preset loss computing formula and the correspondences between temperature rises and accumulated-loss decision values, the preset loss computing formula may be corrected first while the correspondences between temperature rises and accumulated-loss decision values remain unchanged; and the correspondences between temperature rises and accumulated-loss decision values may be corrected when: it is relatively difficult to correct the preset loss computing formula alone in the current working condition and in the working condition before the preset working condition is changed, and the correspondences between temperature rises and accumulated-loss decision values satisfy the determining relationship with the first relationship line and the second relationship line in the range in which the temperature rise is greater than the third threshold but less than the second threshold.

It needs to be noted that, in some examples of the step S500, although the correspondences between temperature rises and accumulated-loss decision values may be obtained through computing according to the preset loss computing formula, after the correspondences between temperature rises and accumulated-loss decision values are determined, the correspondences are no longer affected by the preset loss computing formula; and when the preset loss computing formula changes, the correspondences between temperature rises and accumulated-loss decision values do not change. In other words, in the step S600, the correction of the preset loss computing formula does not cause a change in the correspondences between temperature rises and accumulated-loss decision values.

S700: Repeat S600 until all working conditions of the electronic device are verified, and enable, in each working condition of the electronic device, the correspondences between temperature rises and accumulated-loss decision values to satisfy the determining relationship with the first relationship line and the second relationship line in the range in which the temperature rise is greater than the third threshold but less than the second threshold.

It can be understood that in the step S400, a plurality of second relationship lines may be formed, in the rectangular coordinate system in which the first relationship line is located, based on relationships between temperature rises of the conductive structure that is electrically connected to the heat-emitting component when the electronic device is in a plurality of different abnormal heat dissipation states and computed values of accumulated losses that are computed according to the preset loss computing formula. In this case, in the step S500, the correspondences between temperature rises and accumulated-loss decision values may be obtained based on both a second relationship line, whose portion with temperature rises greater than the third threshold but less than the second threshold is closest to the first relationship line in the same rectangular coordinate system, and the first relationship line.

It can be understood that, when the temperature rise in the method for determining, by the electronic device, whether to perform over-temperature protection is a maximum value or an average value of temperature rises of conductive structures that are respectively and electrically connected to a plurality of heat-emitting components of a same type, the temperature rise in the method for correcting the standard for determining, by the electronic device, whether to perform over-temperature protection is also the maximum value or the average value of the temperature rises of the conductive structures that are respectively and electrically connected to the plurality of heat-emitting components of the same type.

An embodiment of this application further provides an electronic apparatus. The apparatus includes:
an obtaining module, configured to obtain, at an interval of a preset time period, a temperature rise of a conductive structure that is electrically connected to a heat-emitting component at a current moment relative to an initial moment; and
a determining module, configured to determine, based on the temperature rise of the conductive structure that is electrically connected to the heat-emitting component at the current moment relative to the initial moment, whether the electronic apparatus needs to perform over-temperature protection.

In this embodiment of this application, the determining module specifically includes:
a computing unit, configured to obtain, at the interval of the preset time period, a computed value of an accumulated loss of the heat-emitting component at the current moment relative to the initial moment according to a preset loss computing formula;
a first comparing unit, configured to compare the temperature rise obtained at the current moment with a preset first threshold;
a second comparing unit, configured to: when the temperature rise obtained at the current moment is greater than the preset first threshold, obtain, based on preset correspondences between temperature rises and accumulated-loss decision values, an accumulated-loss decision value that corresponds to the temperature rise obtained at the current moment; and compare the obtained accumulated-loss decision value that corresponds to the temperature rise obtained at the current moment with the computed value of the accumulated loss of the heat-emitting component at the current moment relative to the initial moment that is obtained according to the preset loss computing formula; and
a determining unit, configured to: when the temperature rise obtained at the current moment is greater than the preset first threshold, and the computed value of the accumulated loss of the heat-emitting component at the current moment relative to the initial moment that is obtained according to the preset loss computing formula is less than the accumulated-loss decision value that corresponds to the temperature rise obtained at the current moment and that is obtained based on the preset correspondences between temperature rises and accumulated-loss decision values, determine that the electronic device needs to perform over-temperature protection.

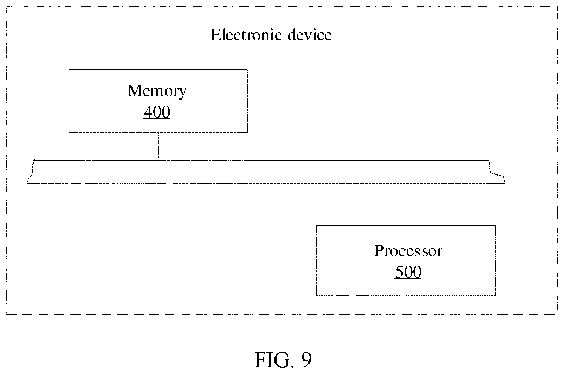

FIG. 9 is a schematic diagram of another electronic device according to an embodiment of this application.

As shown in FIG. 9, an embodiment of this application further provides an electronic device. The device includes a processor 500 and a memory 400. The processor 500 communicates with and connects to the memory 400.

The memory 400 stores computer instructions, and the processor 500 is configured to execute the computer instructions, so as to implement the method for determining, by the electronic device, whether to perform over-temperature protection in any one of the foregoing implementations.

It can be understood that the memory 400 may be independent, or may be integrated with the processor 500.

When the memory 400 is a component independent of the processor 500, the electronic device may further include a bus, where the processor 500 and the memory 400 may communicate with and connect to each other through the bus. The bus may be an industry standard architecture (industrial standard architecture, ISA for short) bus, a peripheral component interconnect (peripheral component interconnect, PCI) bus, an extended industry standard architecture (extended industry standard architecture, EISA) bus, or the like. The bus may be classified into an address bus, a data bus, a control bus, and the like, but this does not mean that there is only one bus or a bus of only one type.

When the memory 400 and the processor 500 are integrated into one chip, the memory 400 and the processor 500 may communicate with and connect to each other through an internal interface.

A communication interface may be further disposed on the processor 500 and the memory 400, where the communication interface is configured to communicate with and connect to another device. The communication interface may include a communication interface used for data transmission, a display interface or an operation interface used for human-machine interaction, or the like.

The processor 500 may be a central processing unit (central processing unit, CPU), or an application-specific integrated circuit (application specific integrated circuit, ASIC), or one or more integrated circuits configured to implement this embodiment of this application. The one or more processors 500 that may be included in the electronic device may be processors of a same type, for example, one or more central processing units; or may be processors of different types, for example, one or more central processing units and one or more application-specific integrated circuits.

The memory 400 may include a high-speed RAM memory, or may include a non-volatile memory such as at least one magnetic disk memory.

An embodiment of this application further provides a computer readable storage medium. The computer readable storage medium stores a computer program. When the computer program is executed by a processor, the method for determining, by an electronic device, whether to perform over-temperature protection in any one of the foregoing implementations is implemented.

It can be understood that, the computer readable storage medium may include any medium that can store program code, such as a USB flash drive, a removable hard disk, a read-only memory (read-only memory, ROM), a random access memory (random access memory, RAM), a magnetic disk, or an optical disc.

In descriptions of embodiments of this application, unless otherwise clearly specified and limited, the terms "installation", "connection to", and "connection" should be understood in a broad sense. For example, the connection may be a fixed connection, may be an indirect connection by using an intermediate medium, or may be an internal connection between two elements or an interaction relationship between two elements. For persons of ordinary skill in the art, specific meanings of the foregoing terms in embodiments of this application may be understood based on a specific situation.

In the specification, claims, and accompanying drawings in embodiments of this application, the terms "first", "second", "third", "fourth", and the like (if available) are intended to distinguish between similar objects but do not necessarily indicate a specific order or sequence.

## Claims

1. A power module (100), comprising a substrate (110), a heat-emitting component (120), and a temperature sensor (130), wherein;
the heat-emitting component (120) and the temperature sensor (130) are both disposed on a surface of the substrate (110);
the substrate (110) comprises a conductive structure (114), the heat-emitting component (120) is electrically connected to the conductive structure (114), and the conductive structure (114) is configured to perform heat exchange with the heat-emitting component (120) electrically connected to the conductive structure (114); and
a projection of the temperature sensor (130) in a thickness dimension of the substrate (110) overlaps at least partially with a projection of the conductive structure (114) in the thickness dimension of the substrate (110), and the temperature sensor (130) is configured to collect a temperature of the conductive structure (114);
wherein the substrate (110) is a printed circuit board;
wherein the substrate (110) comprises at least two conductive layers and an insulation layer (115) that is located between two adjacent conductive layers;
the at least two conductive layers comprise a first conductive layer (111) and a second conductive layer (112) that are respectively located on surfaces that are of the substrate (110) and that are on two sides of the substrate (110) in the thickness dimension of the substrate (110), the temperature sensor (130) is disposed on a surface of the first conductive layer (111), and the heat-emitting component (120) is disposed on a surface of the second conductive layer (112); and
at least one of the conductive layers other than the first conductive layer (111) comprises the conductive structure (114), and there is the insulation layer (115) between the conductive layer in which the conductive structure is located and the first conductive layer (111);
wherein the heat-emitting component (120) is provided with a pin (121), the pin passes through the substrate (110) so as to dispose the heat-emitting component (120) on the surface of the substrate (110), the heat-emitting component (120) is electrically connected to the conductive structure (114) by using the pin (121), the conductive structure (114) is configured to perform heat exchange with the heat-emitting component (120) by using the pin (121), and the temperature sensor (130) and the pin (121) are adjacently disposed.

2. The power module (100) according to claim 1, wherein the projection of the temperature sensor (130) in the thickness dimension of the substrate (110) falls within the projection of the conductive structure (114) in the thickness dimension of the substrate (110).

3. The power module (100) according to claim 1 or 2, wherein the second conductive layer (112) comprises the conductive structure (114).

4. The power module (100) according to claim 1, wherein the substrate (110) comprises at least three conductive layers, and the at least three conductive layers further comprise a third conductive layer (113) that is located between the first conductive layer (111) and the second conductive layer (112); and
the third conductive layer (113) comprises the conductive structure (114).

5. The power module (100) according to any one of claims 1 to 4, wherein the temperature sensor (130) is a surface-mount temperature-sensitive resistor and is mounted on the surface of the substrate (110).

6. The power module (100) according to any one of claims 1 to 4, wherein the power module further comprises a heat sink; and
the heat sink is disposed on a side that is of the heat-emitting component and that is away from the substrate, the heat sink is configured to perform heat exchange with the heat-emitting component, and the temperature sensor and the heat sink are disposed at an interval.

7. A charging pile, comprising a pile body (300), a liquid cooling plate (200), a substrate (110), a heat-emitting component (120), and a temperature sensor (130), wherein the liquid cooling plate, the substrate, the heat-emitting component, and the temperature sensor are all disposed in the pile body;
the heat-emitting component and the temperature sensor are both disposed on a surface of the substrate;
the substrate comprises a conductive structure, the heat-emitting component is electrically connected to the conductive structure, and the conductive structure is configured to perform heat exchange with the heat-emitting component electrically connected to the conductive structure;
a projection of the temperature sensor in a thickness dimension of the substrate overlaps at least partially with a projection of the conductive structure in the thickness dimension of the substrate, and the temperature sensor is configured to collect a temperature of the conductive structure; and
the heat-emitting component is located between the substrate and the liquid cooling plate, and the liquid cooling plate is configured to perform heat exchange with the heat-emitting component;
wherein the substrate is a printed circuit board;
wherein the substrate comprises at least two conductive layers and an insulation layer that is located between two adjacent conductive layers;
the at least two conductive layers comprise a first conductive layer and a second conductive layer that are respectively located on surfaces that are of the substrate and that are on two sides of the substrate in the thickness dimension of the substrate, the temperature sensor is disposed on a surface of the first conductive layer, and the heat-emitting component is disposed on a surface of the second conductive layer; and
at least one of the conductive layers other than the first conductive layer comprises the conductive structure, and there is the insulation layer between the conductive layer in which the conductive structure is located and the first conductive layer;
wherein the heat-emitting component is provided with a pin, the pin passes through the substrate so as to dispose the heat-emitting component on the surface of the substrate, the heat-emitting component is electrically connected to the conductive structure by using the pin, the conductive structure is configured to perform heat exchange with the heat-emitting component by using the pin, and the temperature sensor and the pin are adjacently disposed

8. The charging pile according to claim 7, wherein the projection of the temperature sensor in the thickness dimension of the substrate falls within the projection of the conductive structure in the thickness dimension of the substrate

9. The charging pile according to claim 7 or 8, wherein the second conductive layer comprises the conductive structure

10. The charging pile according to claim 7, wherein the substrate comprises at least three conductive layers, and the at least three conductive layers further comprise a third conductive layer that is located between the first conductive layer and the second conductive layer; and
the third conductive layer comprises the conductive structure

## Patentansprüche

1. Leistungsmodul (100), das ein Substrat (110), eine Wärmeabgabekomponente (120) und einen Temperatursensor (130) umfasst, wobei;
die Wärmeabgabekomponente (120) und der Temperatursensor (130) beide auf einer Oberfläche des Substrats (110) angeordnet sind; das Substrat (110) eine leitfähige Struktur (114) umfasst, die Wärmeabgabekomponente (120) elektrisch mit der leitfähigen Struktur (114) verbunden ist und die leitfähige Struktur (114) dazu konfiguriert ist, einen Wärmeaustausch mit der Wärmeabgabekomponente (120) durchzuführen, die elektrisch mit der leitfähigen Struktur (114) verbunden ist; und
ein vorstehender Teil des Temperatursensors (130) in einer Dickenabmessung des Substrats (110) zumindest teilweise mit einem vorstehenden Teil der leitfähigen Struktur (114) in der Dickenabmessung des Substrats (110) überlappt, und der Temperatursensor (130) dazu konfiguriert ist, eine Temperatur der leitfähigen Struktur (114) zu erfassen;
wobei das Substrat (110) eine Leiterplatte ist;
wobei das Substrat (110) mindestens zwei leitfähige Schichten und eine Isolierschicht (115) umfasst, die sich zwischen zwei benachbarten leitfähigen Schichten befindet;
wobei die mindestens zwei leitfähigen Schichten eine erste leitfähige Schicht (111) und eine zweite leitfähige Schicht (112) umfassen, die sich jeweils auf Oberflächen des Substrats (110) und auf zwei Seiten des Substrats (110) in der Dickenabmessung des Substrats (110) befinden, der Temperatursensor (130) auf einer Oberfläche der ersten leitfähigen Schicht (111) angeordnet ist und die Wärmeabgabekomponente (120) auf einer Oberfläche der zweiten leitfähigen Schicht (112) angeordnet ist; und
mindestens eine der leitfähigen Schichten außer der ersten leitfähigen Schicht (111) die leitfähige Struktur (114) aufweist, und sich die Isolierschicht (115) zwischen der leitfähigen Schicht, in der sich die leitfähige Struktur befindet, und der ersten leitfähigen Schicht (111) befindet;
wobei die Wärmeabgabekomponente (120) mit einem Stift (121) versehen ist, der Stift durch das Substrat (110) verläuft, um die Wärmeabgabekomponente (120) auf der Oberfläche des Substrats (110) anzuordnen, die Wärmeabgabekomponente (120) durch den Stift (121) elektrisch mit der leitfähigen Struktur (114) verbunden ist, die leitfähige Struktur (114) dazu konfiguriert ist, durch den Stift (121) einen Wärmeaustausch mit der Wärmeabgabekomponente (120) durchzuführen, und der Temperatursensor (130) und der Stift (121) benachbart angeordnet sind.

2. Leistungsmodul (100) nach Anspruch 1, wobei der vorstehende Teil des Temperatursensors (130) in der Dickenabmessung des Substrats (110) innerhalb des vorstehenden Teils der leitfähigen Struktur (114) in der Dickenabmessung des Substrats (110) liegt.

3. Leistungsmodul (100) nach Anspruch 1 oder 2, wobei die zweite leitfähige Schicht (112) die leitfähige Struktur (114) umfasst.

4. Leistungsmodul (100) nach Anspruch 1, wobei das Substrat (110) mindestens drei leitfähige Schichten umfasst und die mindestens drei leitfähigen Schichten ferner eine dritte leitfähige Schicht (113) umfassen, die sich zwischen der ersten leitfähigen Schicht (111) und der zweiten leitfähigen Schicht (112) befindet; und
die dritte leitfähige Schicht (113) die leitfähige Struktur (114) umfasst.

5. Leistungsmodul (100) nach einem der Ansprüche 1 bis 4, wobei der Temperatursensor (130) ein oberflächenmontierter temperaturempfindlicher Widerstand ist und auf der Oberfläche des Substrats (110) montiert ist.

6. Leistungsmodul (100) nach einem der Ansprüche 1 bis 4, wobei das Leistungsmodul ferner einen Kühlkörper umfasst; und
der Kühlkörper auf einer Seite mit der Wärmeabgabekomponente angeordnet ist, die vom Substrat abgewandt ist, wobei der Kühlkörper dazu konfiguriert ist, einen Wärmeaustausch mit der Wärmeabgabekomponente durchzuführen, und der Temperatursensor und der Kühlkörper in einem Abstand angeordnet sind.

7. Ladesäule, die einen Säulenkörper (300), eine Flüssigkeitskühlplatte (200), ein Substrat (110), eine Wärmeabgabekomponente (120) und einen Temperatursensor (130) umfasst, wobei die Flüssigkeitskühlplatte, das Substrat, die Wärmeabgabekomponente und der Temperatursensor alle im Säulenkörper angeordnet sind;
wobei die Wärmeabgabekomponente und der Temperatursensor beide auf einer Oberfläche des Substrats angeordnet sind;
das Substrat eine leitfähige Struktur umfasst, die Wärmeabgabekomponente elektrisch mit der leitfähigen Struktur verbunden ist und die leitfähige Struktur dazu konfiguriert ist, einen Wärmeaustausch mit der Wärmeabgabekomponente durchzuführen, die elektrisch mit der leitfähigen Struktur verbunden ist;
ein vorstehender Teil des Temperatursensors in einer Dickenabmessung des Substrats zumindest teilweise mit einem vorstehenden Teil der leitfähigen Struktur in der Dickenabmessung des Substrats überlappt, und der Temperatursensor dazu konfiguriert ist, eine Temperatur der leitfähigen Struktur zu erfassen; und
sich die Wärmeabgabekomponente zwischen dem Substrat und der Flüssigkeitskühlplatte befindet, und die Flüssigkeitskühlplatte dazu konfiguriert ist, einen Wärmeaustausch mit der Wärmeabgabekomponente durchzuführen;
wobei das Substrat eine Leiterplatte ist;
wobei das Substrat mindestens zwei leitfähige Schichten und eine Isolierschicht umfasst, die sich zwischen zwei benachbarten leitfähigen Schichten befindet;
wobei die mindestens zwei leitfähigen Schichten eine erste leitfähige Schicht und eine zweite leitfähige Schicht umfassen, die sich jeweils auf Oberflächen des Substrats und auf zwei Seiten des Substrats in der Dickenabmessung des Substrats befinden, der Temperatursensor auf einer Oberfläche der ersten leitfähigen Schicht angeordnet ist und die Wärmeabgabekomponente auf einer Oberfläche der zweiten leitfähigen Schicht angeordnet ist; und mindestens eine der leitfähigen Schichten außer der ersten leitfähigen Schicht die leitfähige Struktur aufweist, und sich die Isolierschicht zwischen der leitfähigen Schicht, in der sich die leitfähige Struktur befindet, und der ersten leitfähigen Schicht befindet;
wobei die Wärmeabgabekomponente mit einem Stift versehen ist, der Stift durch das Substrat verläuft, um die Wärmeabgabekomponente auf der Oberfläche des Substrats anzuordnen, die Wärmeabgabekomponente durch den Stift elektrisch mit der leitfähigen Struktur verbunden ist, die leitfähige Struktur dazu konfiguriert ist, durch den Stift einen Wärmeaustausch mit der Wärmeabgabekomponente durchzuführen, und der Temperatursensor und der Stift benachbart angeordnet sind.

8. Ladesäule nach Anspruch 7, wobei der vorstehende Teil des Temperatursensors in der Dickenabmessung des Substrats innerhalb des vorstehenden Teils der leitfähigen Struktur in der Dickenabmessung des Substrats liegt.

9. Ladesäule nach Anspruch 7 oder 8, wobei die zweite leitfähige Schicht die leitfähige Struktur umfasst.

10. Ladesäule nach Anspruch 7, wobei das Substrat mindestens drei leitfähige Schichten umfasst und die mindestens drei leitfähigen Schichten ferner eine dritte leitfähige Schicht umfassen, die sich zwischen der ersten leitfähigen Schicht und der zweiten leitfähigen Schicht befindet; und
die dritte leitfähige Schicht die leitfähige Struktur umfasst.

## Revendications

1. Module d'alimentation (100), comprenant un substrat (110), un composant émetteur de chaleur (120) et un capteur de température (130), dans lequel ;
le composant émetteur de chaleur (120) et le capteur de température (130) sont tous deux disposés sur une surface du substrat (110) ;
le substrat (110) comprend une structure conductrice (114), le composant émetteur de chaleur (120) est connecté électriquement à la structure conductrice (114), et la structure conductrice (114) est configurée pour effectuer un échange de chaleur avec le composant émetteur de chaleur (120) connecté électriquement à la structure conductrice (114) ; et
une projection du capteur de température (130) dans une dimension d'épaisseur du substrat (110) chevauche au moins partiellement une projection de la structure conductrice (114) dans la dimension d'épaisseur du substrat (110), et le capteur de température (130) est configuré pour collecter une température de la structure conductrice (114) ;
dans lequel le substrat (110) est une carte de circuit imprimé ; dans lequel le substrat (110) comprend au moins deux couches conductrices et une couche isolante (115) qui est située entre deux couches conductrices adjacentes ;
les au moins deux couches conductrices comprennent une première couche conductrice (111) et une deuxième couche conductrice (112) qui sont respectivement situées sur des surfaces du substrat (110) et qui sont sur deux côtés du substrat (110) dans la dimension d'épaisseur du substrat (110), le capteur de température (130) est disposé sur une surface de la première couche conductrice (111), et le composant émetteur de chaleur (120) est disposé sur une surface de la deuxième couche conductrice (112) ; et
au moins l'une des couches conductrices autres que la première couche conductrice (111) comprend la structure conductrice (114), et il y a la couche isolante (115) entre la couche conductrice dans laquelle se trouve la structure conductrice et la première couche conductrice (111) ;
dans lequel le composant émetteur de chaleur (120) est pourvu d'une broche (121), la broche traverse le substrat (110) de manière à disposer le composant émetteur de chaleur (120) sur la surface du substrat (110), le composant émetteur de chaleur (120) est connecté électriquement à la structure conductrice (114) à l'aide de la broche (121), la structure conductrice (114) est configurée pour effectuer un échange de chaleur avec le composant émetteur de chaleur (120) à l'aide de la broche (121), et le capteur de température (130) et la broche (121) sont disposés de manière adjacente.

2. Module d'alimentation (100) selon la revendication 1, dans lequel la projection du capteur de température (130) dans la dimension d'épaisseur du substrat (110) tombe à l'intérieur de la projection de la structure conductrice (114) dans la dimension d'épaisseur du substrat (110).

3. Module d'alimentation (100) selon la revendication 1 ou 2, dans lequel la deuxième couche conductrice (112) comprend la structure conductrice (114).

4. Module d'alimentation (100) selon la revendication 1, dans lequel le substrat (110) comprend au moins trois couches conductrices, et les au moins trois couches conductrices comprennent également une troisième couche conductrice (113) qui est située entre la première couche conductrice (111) et la deuxième couche conductrice (112) ; et
la troisième couche conductrice (113) comprend la structure conductrice (114).

5. Module d'alimentation (100) selon l'une quelconque des revendications 1 à 4, dans lequel le capteur de température (130) est une résistance sensible à la température montée en surface et est monté sur la surface du substrat (110).

6. Module d'alimentation (100) selon l'une quelconque des revendications 1 à 4, dans lequel le module d'alimentation comprend également un dissipateur thermique ; et
le dissipateur thermique est disposé sur un côté qui est du composant émetteur de chaleur et qui est éloigné du substrat, le dissipateur thermique est configuré pour effectuer un échange de chaleur avec le composant émetteur de chaleur, et le capteur de température et le dissipateur thermique sont disposés à un intervalle.

7. Pile de charge, comprenant un corps de pile (300), une plaque de refroidissement liquide (200), un substrat (110), un composant émetteur de chaleur (120) et un capteur de température (130), dans laquelle la plaque de refroidissement liquide, le substrat, le composant émetteur de chaleur et le capteur de température sont tous disposés dans le corps de pile ;
le composant émetteur de chaleur et le capteur de température sont tous deux disposés sur une surface du substrat ;
le substrat comprend une structure conductrice, le composant émetteur de chaleur est connecté électriquement à la structure conductrice, et la structure conductrice est configurée pour effectuer un échange de chaleur avec le composant émetteur de chaleur connecté électriquement à la structure conductrice ;
une projection du capteur de température dans une dimension d'épaisseur du substrat chevauche au moins partiellement une projection de la structure conductrice dans la dimension d'épaisseur du substrat, et le capteur de température est configuré pour collecter une température de la structure conductrice ; et
le composant émetteur de chaleur est situé entre le substrat et la plaque de refroidissement liquide, et la plaque de refroidissement liquide est configurée pour effectuer un échange de chaleur avec le composant émetteur de chaleur ;
dans laquelle le substrat est une carte de circuit imprimé ;
dans laquelle le substrat comprend au moins deux couches conductrices et une couche isolante qui est située entre deux couches conductrices adjacentes ;
les au moins deux couches conductrices comprennent une première couche conductrice et une deuxième couche conductrice qui sont respectivement situées sur des surfaces du substrat et qui sont sur deux côtés du substrat dans la dimension d'épaisseur du substrat, le capteur de température est disposé sur une surface de la première couche conductrice, et le composant émetteur de chaleur est disposé sur une surface de la deuxième couche conductrice ; et
au moins l'une des couches conductrices autres que la première couche conductrice comprend la structure conductrice, et il y a la couche isolante entre la couche conductrice dans laquelle se trouve la structure conductrice et la première couche conductrice ;
dans laquelle le composant émetteur de chaleur est pourvu d'une broche, la broche traverse le substrat de manière à disposer le composant émetteur de chaleur sur la surface du substrat, le composant émetteur de chaleur est connecté électriquement à la structure conductrice à l'aide de la broche, la structure conductrice est configurée pour effectuer un échange de chaleur avec le composant émetteur de chaleur à l'aide de la broche, et le capteur de température et la broche sont disposés de manière adjacente.

8. Pile de charge selon la revendication 7, dans laquelle la projection du capteur de température dans la dimension d'épaisseur du substrat tombe dans la projection de la structure conductrice dans la dimension d'épaisseur du substrat.

9. Pile de charge selon la revendication 7 ou 8, dans laquelle la deuxième couche conductrice comprend la structure conductrice.

10. Pile de charge selon la revendication 7, dans laquelle le substrat comprend au moins trois couches conductrices, et les au moins trois couches conductrices comprennent également une troisième couche conductrice qui est située entre la première couche conductrice et la deuxième couche conductrice ; et
la troisième couche conductrice comprend la structure conductrice.
